# EUROPÄISCHE PATENTSCHRIFT

(11) **EP 2 849 548 B1**
(45) Veröffentlichungstag und Bekanntmachung des Hinweises auf die Patenterteilung: **24.02.2021**
(21) Anmeldenummer: 14178277.1
(22) Anmeldetag: 24.07.2014
(51) Int. Cl.: H05K 3/34

(54) **Verfahren zum Herstellen einer Lötverbindung und Schaltungsbauteil**
Method for creating a soldered connection and circuit component
Procédé de fabrication d'une liaison soudée et composant de circuit

(30) Priorität: 13.09.2013 DE 102013218425
(43) Veröffentlichungstag der Anmeldung: 18.03.2015
(73) Patentinhaber: Robert Bosch GmbH, 70442 Stuttgart (DE)
(72) Erfinder: Herberholz, Timo, 70188 Stuttgart (DE); Fix, Andreas, 70439 Stuttgart (DE)

(56) Entgegenhaltungen:
- EP-A1- 2 560 468
- JP-A- 2013 161 544
- US-A1- 2007 074 391
- US-A1- 2012 103 678
- US-A1- 2012 211 764
- US-A1- 2013 049 204
- YEHESKEL O ET AL: "Evolution of the elastic moduli at the early stage of copper sintering", MATERIALS LETTERS, ELSEVIER, AMSTERDAM, NL, vol. 57, no. 28, 1 October 2003 (2003-10-01), pages 4418-4423, XP004458419, ISSN: 0167-577X, DOI: 10.1016/S0167-577X(03)00334-3

## Beschreibung

### Stand der Technik

Die Erfindung betrifft ein Verfahren zum Herstellen einer Lötverbindung nach Gattung des Anspruchs 1. Ferner betrifft die Erfindung ein Schaltungsbauteil, das unter Verwendung des erfindungsgemäßen Verfahrens hergestellt ist.

Ein Verfahren nach zum Herstellen einer Lötverbindung ist zum Beispiel aus der US 5,429,293 bekannt. Bei dem bekannten Verfahren wird auf den lötbaren Bereich eines Schaltungsträgers, der in Form einer Leiterplatte ausgebildet ist, zunächst eine erste Lotschicht aufgebracht. Auf die erste Lotschicht wird anschließend eine zweite Schicht, bestehend aus einer Lotpaste mit hochtemperaturfesten Partikeln und Zusatzkomponenten, beispielsweise Flussmittel, aufgebracht.

Anschließend wird der so ausgebildete Verbund einer Wärmebehandlung ausgesetzt, bei der zunächst die erste Schicht, die einen geringeren Schmelzpunkt aufweist als die zweite Schicht, aufgeschmolzen wird und sich mit der darüberliegenden, zweiten Schicht vermengt, wobei die zweite Schicht in festem Zustand bestehen bleibt. Dabei verbinden sich die verflüssigten Bestandteile der ersten Schicht mit den festen Bestandteilen der zweiten Schicht.

Auf eine derart ausgebildete Leiterplatte können anschließend (elektronische) Bauteile aufgebracht werden, die in einem nachgeschalteten Lötverfahren, insbesondere einer Reflow-Lötung, anschließend mit der Leiterplatte verbunden werden. Bei dem bekannten Verfahren besteht die Tendenz, dass die Oberfläche der die Partikel enthaltenden zweiten Schicht Poren aufweist, die im Verbindungsbereich mit einem elektronischen Bauteil die Qualität der Lötverbindung herabsetzt. insbesondere ist dadurch, dass die erste Schicht in Bezug zur Ebene der Leiterplatte unterhalb der zweiten Schicht angeordnet ist, nicht sichergestellt, dass bei der Wärmebehandlung die verflüssigte erste Schicht die Poren der oberhalb der ersten Schicht angeordneten zweiten Schicht vollständig ausfüllt.

Weiterhin ist aus dem Stand der Technik das sogenannte Diffusionslöten bekannt, das eine bleifreie Verbindungstechnologie auf der Basis des Prinzips der isothermen Erstarrung darstellt. Dabei wird üblicherweise eine niedrig schmelzende Lotschicht zwischen zwei hochschmelzenden Metallschichten angeordnet. Bei einer Erhitzung reagiert die niedrig schmelzende Lotschicht unter Ausbildung intermetallischer Verbindungen, die einen Schmelzpunkt aufweisen, der höher ist als der des niedrig schmelzenden Lotes.

Ein Verfahren zum Herstellen einer Lötverbindung nach dem Oberbegriff des Anspruchs 1 ist aus der US 2012/0211764 A1 bekannt.

Weiterhin ist es aus der JP 2013 161544 A zur Ausbildung von Leiterbahnenstrukturen bekannt, aus Kostengründen Metallpartikel zu verwenden, die eine Mischung von verschiedenen Partikelgrößen sowohl im Mikrometer-Bereich als auch im Nanometer-Bereich aufweisen.

### Offenbarung der Erfindung

### Vorteile der Erfindung

Das erfindungsgemäße Verfahren mit den Merkmalen des unabhängigen Anspruchs bietet die Möglichkeit eine qualitativ besonders gute Lötverbindung mit einem zu verbindenden Bauteil zu erzielen. Es kann eine zumindest nahezu porenfreie Oberfläche der Verbindungsstelle bzw. Verbindungsschicht nach dem Ausbilden der Lötverbindung erzielt werden.

Ein weiterer Vorteil besteht darin, dass unter Verwendung konventioneller Anlagentechnik eine Vielzahl unterschiedlicher Bauteile bei geringer Prozessdauer und geringer thermischer Belastung der Bauteile verlötet werden kann. Weiterhin kann durch das erfindungsgemäße Verfahren die Temperaturstabilität durch eine Auslöttemperatur, die höher ist als die Prozesstemperatur, erhöht werden.

Diese Vorteile werden erzielt durch ein Verfahren zum Herstellen einer Lötverbindung, bei dem auf ein Trägerelement wenigstens eine erste Schicht und eine zweite Schicht aufgebracht werden, wobei die erste Schicht zumindest Metallpartikel und Zusatzstoffe, insbesondere Flussmittel, aufweist, wobei die zweite Schicht zumindest Lotmittel aufweist, wobei das Trägerelement und die wenigstens zwei Schichten anschließend einer Wärmebehandlung unterzogen werden, bei der die zweite Schicht verflüssigt wird und in die Struktur der ersten Schicht eindringt, wobei die erste Schicht und die zweite Schicht ohne gegenseitige Überdeckung auf das TrägereIement aufgebracht werden. Erfindungsgemäß ist einer der Zusatzstoffe Lotpulver, insbesondere Lotpulver mit einer Körnung von 1 µm bis 100 µm.

Ein weiterer Vorteil des erfindungsgemäßen Verfahrens besteht darin, dass durch das Aufbringen ohne gegenseitige Überdeckung der ersten Schicht und der zweiten Schicht Gase, die während der Wärmebehandlung in der ersten Schicht und/oder der zweiten Schicht entstehen, besonders gut entweichen können. Hierdurch wird eine besonders stabile Verbindung mit besonders großer Anbindungsfläche erreicht.

Durch die in den Unteransprüchen aufgeführten Maßnahmen sind vorteilhafte Weiterbildungen und Verbesserungen des im Hauptanspruch angegebenen Verfahrens möglich.

Im Verlauf der Wärmebehandlung versintern zunächst die Metallpartikel der ersten Schicht unter Bildung einer Hohlräume aufweisenden Gitterstruktur und wird anschließend das Material der zweiten Schicht verflüssigt und dringt in die Hohlräume bzw. Poren der Gitterstruktur der ersten Schicht ein. Dadurch wird es ermöglicht, dass die Poren in der Gitterstruktur durch eine Infiltration mit dem flüssigen Lot besonders gut verschlossen werden.

Außerdem weist die Gitterstruktur eine besonders große Reaktionsoberfläche auf, was nach dem Lötprozess zu einer beschleunigten isothermen Erstarrung unter Bildung einer intermetallischen Phase zwischen der Gitterstruktur und dem Lot führt. Dies führt zu besonders kurzen Prozesszeiten. Wenn das Material der zweiten Schicht zumindest die an einer Oberfläche der ersten Schicht aufgrund der Gitterstruktur ausgebildeten Poren auffüllt, ergibt sich eine besonders stabile Lötverbindung.

In einem nicht erfindungsgemäßen Verfahren wird die erste Schicht zumindest abschnittsweise die zweite Schicht überragend auf das Trägerelement aufgebracht und vor dem Durchführen der Wärmebehandlung ein Bauteil, insbesondere ein elektronisches Bauteil, zumindest abschnittsweise auf der ersten Schicht angeordnet. Somit liegt das elektronische Bauteil stabil auf der ersten Schicht auf und ein Aufschwimmen des elektronischen Bauteils bei dem Schmelzen der zweiten Schicht wird vermieden.

In einem alternativen, nicht erfindungsgemäßen Verfahren wird die zweite Schicht zumindest abschnittsweise die erste Schicht überragend auf das Trägerelement aufgebracht, vor dem Durchführen der Wärmebehandlung ein Bauteil, insbesondere ein elektronisches Bauteil, zumindest abschnittsweise auf der zweiten Schicht angeordnet und vor dem Durchführen der Wärmebehandlung das Bauteil durch Andrücken auf die Höhe der ersten Schicht gebracht. Somit liegt das elektronische Bauteil sowohl auf der ersten Schicht als auch auf der zweiten Schicht auf. Auch in dieser Anordnung wird ein Aufschwimmen des elektronischen Bauteils bei dem Schmelzen der zweiten Schicht vermieden.

Als geeignete Materialien für die Metallpartikel haben sich Partikel aus Kupfer, Bronze, Nickel, Zink und Messing mit einer Partikelgröße zwischen 1 µm und 100 µm erwiesen.

In einer vorteilhaften Weiterbildung des erfindungsgemäßen Verfahrens umfasst die erste Schicht eine Anordnung aus mehreren ersten Teilbereichen und die zweite Schicht ist zwischen den ersten Teilbereichen und/oder um die ersten Teilbereiche angeordnet. Hierbei können die ersten Teilbereiche, je nach Erfordernissen der zu kontaktierenden Bauteile, eine unterschiedliche Form aufweisen. Beispielsweise können diese in Draufsicht quadratisch, oval oder rund ausgebildet werden. Bei einer derartigen Ausbildung wird durch die unterschiedlichen Teilbereiche eine sichere Auflage bzw. Anordnung eines elektronischen Bauteils im Bezug zum Schaltungsträger erreicht, während durch das die ersten Teilbereiche umgebende Lotmittel eine besonders sichere Anbindung bzw. Verbindung zwischen dem Schaltungsträger und dem Bauteil ermöglicht wird.

Befindet sich dabei Lot um die äußeren ersten Teilbereiche herum, wird sichergestellt, dass auch seitliche Bereiche der die Metallpartikel enthaltenden ersten Schicht bei dem Verflüssigen der Lotmittelschicht in Wirkverbindung mit der Lotmittelschicht gelangen und somit auch in diesen Bereichen die Poren an der Oberfläche der ersten Schicht geschlossen werden.

Es kann jedoch auch vorgesehen sein, dass die das Lotmittel enthaltende zweite Schicht lediglich zwischen den ersten Teilbereichen der ersten Schicht angeordnet ist. Bei einer derartigen Ausbildung wird der Vorteil erzielt, dass beim Verflüssigen der Lotschicht insbesondere das Lotmittel nicht über den Bereich der die Metallpartikel enthaltenden ersten Schicht seitlich herausragt, so dass eine besonders hohe Schaltungsdichte auf einem Schaltungsträger erzielt werden kann, da die Bauteile relativ nahe zueinander angeordnet werden können, ohne dass die Gefahr besteht, dass die Kontaktbereiche von nebeneinanderliegenden Bauteilen durch die Lotschicht kurzgeschlossen werden. Darüber hinaus haben auch verschiedene Druckgeometrien einen Einfluss auf die thermomechanischen Eigenschaften und somit auch auf die Lebensdauer einer Schaltung.

Das erfindungsgemäße Schaltungsbauteil zeigt ebenfalls die oben genannten Vorteile.

### Ausführungsbeispiel

### Zeichnungen

Ausführungsbeispiele der Erfindung sind in den Zeichnungen dargestellt und nachfolgend näher erläutert. Es zeigen:
- Figur 1: einen Ausschnitt aus einem mit einem mit einem elektronischen Bauteil bestückten Schaltungsbauteil,
- Figur 2: einen Schnitt durch ein erstes Ausführungsbeispiel für eine Ausbildung eines Kontaktbereiches, wie er zur Herstellung einer Lötverbindung gemäß Fig. 1 verwendet werden kann,
- Figur 3a: einen Schnitt durch ein zweites Ausführungsbeispiel für eine Ausbildung eines Kontaktbereiches, wie er zur Herstellung einer Lötverbindung gemäß Fig. 1 verwendet werden kann, vor einem Andrücken des Bauteils
- Figur 3b: einen Schnitt durch das in Fig. 3a dargestellte Ausführungsbeispiel für eine Ausbildung eines Kontaktbereiches nach einem Andrücken des Bauteils

### Beschreibung des Ausführungsbeispiels

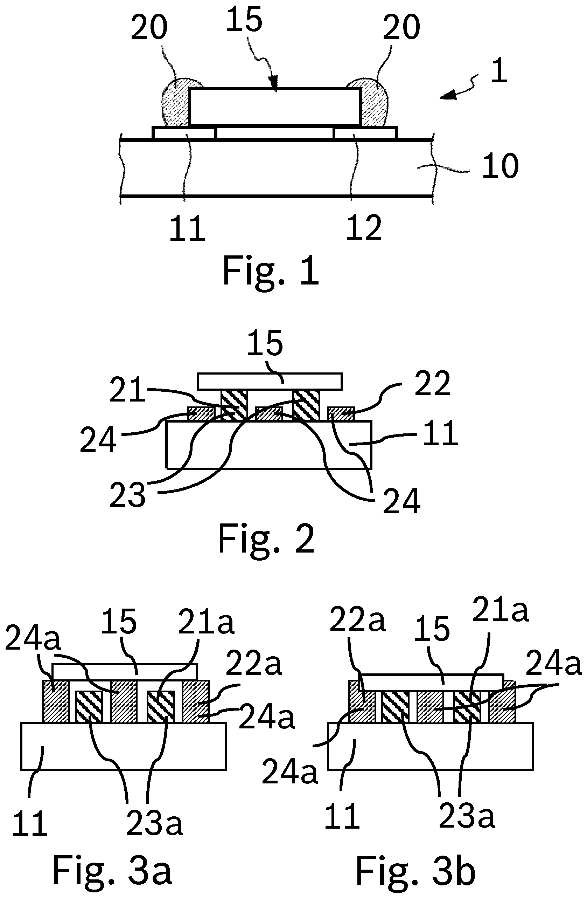

Figur 1 zeigt einen Ausschnitt eines Schaltungsbauteils 1, wie es beispielsweise in einem Kraftfahrzeug verwendet wird. Das Schaltungsbauteil 1 weist ein Trägerelement 10 in Form einer bedruckten Leiterplatte (PCB) auf, auf deren Oberseite elektrisch leitende Bereiche 11, 12 angeordnet sind.

Es sind jedoch auch weitere Ausführungsformen der Erfindung denkbar, in denen als Schaltungsträger 10 beispielsweise keramische Substrate oder (Kupfer-) Stanzgitter verwendet werden.

Die Bereiche 11, 12 dienen der elektrischen Kontaktierung eines beispielsweise als SMD-Bauteil 15 ausgebildeten elektronischen Bauelements. SMD steht dabei für surface-mounted device beziehungsweise oberflächenmontiertes Bauelement. Dabei wird das SMD-Bauteil 15 mit den Bereichen 11, 12 mittels einer Lötverbindung 20 mit zwei Lötstellen verbunden.

In Fig. 2 und 3a beziehungsweise 3b ist jeweils einer der beiden Bereiche 11, 12, im Ausführungsbeispiel jeweils der Bereich 11, dargestellt, wie er zur Vorbereitung der Lötverbindung 20 mit dem SMD-Bauteil 15 vorgesehen ist.

In der Fig. 2 ist erkennbar, dass auf den leitenden Bereich 11 des Trägerelements 10 eine erste Schicht 21 aufgebracht ist, wobei die erste Schicht 21 aus Metallpartikeln und Zusatzstoffen besteht. Die erste Schicht 21 ist in Form einer Metallpaste ausgebildet. Bei den Metallpartikeln handelt es sich erfindungsgemäß um Partikel aus Kupfer, Bronze, Nickel, Zink oder Messing mit einer Partikelgröße zwischen 1 µm und 100 µm. Als weitere nicht erfindungsgemäße Materialien kommen beispielsweise Eisen, Titan und deren Legierungen infrage.

Die Schichtdicke der ersten Schicht 21 beträgt typischerweise zwischen 10 µm und 150 µm, bevorzugt zwischen 10 µm und 100 µm. Für die Schichtdicke der ersten Schicht 21 können ähnliche Schichtdicken wie bei der Verwendung konventioneller Lote verwendet werden.

Bei den Zusatzstoffen handelt es sich insbesondere um ein Flussmittel, jedoch können auch noch andere Zusatzstoffe alternativ oder ergänzend verwendet werden. So kann beispielsweise ein Trägermedium bzw. Dispergiermittel verwendet werden, das ggf. Flussmitteleigenschaften aufweist, oder ein Lösungsmittel. Das Metallpulver wird erfindungsgemäß mit Lotpulver gemischt. Dabei eignet sich besonders gut Lotpulver mit einer Körnung von 1 µm bis 100 µm.

Das Aufbringen der ersten Schicht 21 auf den Bereich 11 des Trägerelementes 10 erfolgt insbesondere durch Aufdrucken der ersten Schicht 21, es können alternativ, abhängig von den Randbedingungen jedoch auch andere, an sich bekannte Technologien verwendet werden.

In dem in Fig. 2 dargestellten Ausführungsbeispiel erkennt man in vertikaler Richtung zwei voneinander beabstandet aufgebrachte erste Teilbereiche 23 der ersten Schicht 21. In anderen Ausführungsbeispielen sind beliebige andere Anzahlen an ersten Teilbereichen 23 möglich, die an das konkrete zu verlötende Bauteil 15 angepasst sein können. Auch senkrecht zur Papierebene können mehrere erste Teilbereiche 23 vorhanden sein.

Neben die erste Schicht 21 ist vorzugsweise nass in nass beziehungsweise in diesem Fall nass neben nass eine zweite Schicht 22 aufgebracht. Wenn in das Verfahren zum Herstellen der Lotverbindung 20 ein Trocknungsschritt eingeführt wird, ist es beispielsweise auch denkbar, die zweite Schicht 22 nass neben trocken neben die erste Schicht 21 aufzubringen.

Bei der zweiten Schicht 22 handelt es sich bevorzugt um eine bleifreie Hart- oder Weichlotpaste, die, in Analogie zur ersten Schicht 21, auf den leitenden Bereich 11 des Trägerelements 10 aufgedruckt wird. Für die zweite Schicht werden vorzugsweise bleifreie Lotmittel verwendet. Die dabei erforderlichen Temperaturen zur Verflüssigung des Lotmittels betragen dabei typischerweise, je nach verwendetem Material, etwa maximal 138 °C bis 250 °C.

Die Schichtdicke der zweiten Schicht 22 beträgt typischerweise zwischen 10 µm und 150 µm, bevorzugt zwischen 10 µm und 100 µm. Für die Schichtdicke der zweiten Schicht 22 können ähnliche Schichtdicken wie bei der Verwendung konventioneller Lote verwendet werden.

Die erste Schicht 21 überragt in dem in Fig. 2 dargestellten Ausführungsbeispiel die zweite Schicht 22. Im Sinne der Erfindung ist hierunter zu verstehen, dass die erste Schicht 21 in vertikaler Richtung eine größere Dimension aufweist als die zweite Schicht. Die erste Schicht 21 überdeckt die zweite Schicht 22 jedoch nicht. Unter Überdeckung wäre im Sinne der Erfindung zu verstehen, dass die erste Schicht 21 und die zweite Schicht 22 in vertikaler Richtung eine Kontaktfläche aufweisen.

Dadurch, dass die erste Schicht 21 in dem in Fig. 2 dargestellten Ausführungsbeispiel die zweite Schicht 22 überragt, liegt das elektronische Bauteil 15 auf der ersten Schicht 21 auf. Dies hat den Vorteil, dass bei der Durchführung des Lötprozesses, der weiter unten beschrieben wird, das elektronische Bauteil 15 auch dann auf einer stabilen Unterlage aufliegt, wenn Temperaturen erreicht werden, bei denen die Verflüssigung der zweiten Schicht 22 einsetzt.

In dem in Fig. 2 dargestellten Ausführungsbeispiel erkennt man in horizontaler Richtung drei voneinander beabstandet aufgebrachte zweite Teilbereiche 24 der zweiten Schicht 21. In anderen Ausführungsbeispielen sind beliebige andere Anzahlen an zweiten Teilbereichen 24 möglich, die an das konkrete zu verlötende Bauteil 15 angepasst sein können. Auch senkrecht zur Papierebene können mehrere zweite Teilbereiche 24 vorhanden sein.

In diesem Ausführungsbeispiel ist ein zweiter Teilbereich 24 der zweiten Schicht 22 zwischen den beiden ersten Teilbereichen 23 der ersten Schicht 21 angeordnet und zwei zweite Teilbereiche 24 der zweiten Schicht 23 sind um die beiden ersten Teilbereiche 23 der ersten Schicht 21 angeordnet. Unterer Letzterem ist im Sinne der Erfindung zu verstehen, dass die Anordnung aus ersten Teilbereichen 23 der ersten Schicht 21 und zweiten Teilbereichen 24 der zweiten Schicht 22 in vertikaler Richtung nach außen von zweiten Teilbereichen 24 der zweiten Schicht 23 begrenzt werden.

Insgesamt ist es dabei vorteilhaft, wenn jeweils ein erster Teilbereich 23 der ersten Schicht 21 sich in vertikaler Richtung beziehungsweise auch in der hier nicht dargestellten Richtung senkrecht zur Papierebene mit einem zweiten Teilbereich 24 der zweiten Schicht 22 abwechselt.

Es liegt auch im Rahmen der Erfindung, die Form der Teilbereiche 23, 24 sowie deren Anordnung und Anzahl unterschiedlich von der in der Fig. 2 dargestellten Anordnung auszubilden. Insbesondere können die Teilbereiche 23, 24 beispielsweise eine ovale, runde oder n-eckige Form aufweisen.

In dem in Fig. 2 beschriebenen Ausführungsbeispiel wurde zunächst die zweite Schicht 22 auf das Trägerelement 10 aufgedruckt und anschließend die erste Schicht 21. Da sich die Schichten 21, 22 im Sinne dieser Erfindung nicht überdecken, sind jedoch viele Ausführungsbeispiele denkbar, in denen die Reihenfolge des Aufbringen der ersten Schicht 21 und der zweiten Schicht 22 irrelevant ist.

Die ersten Teilbereiche 23 der ersten Schicht 21 und die zweiten Teilbereiche 24 der zweiten Schicht 22 sind in dem Ausführungsbeispiel in Fig. 2 beabstandet zueinander auf das Trägerelement 10 aufgebracht. Dabei ist die Beabstandung zwischen den beiden Schichten 21, 22 prozessbedingt, da in diesem Ausführungsbeispiel die Schichten 21, 22 nacheinander gedruckt wurden. Es sind jedoch auch, je nach Verfahren zur Aufbringung der Schichten 21, 22 Ausführungsbeispiele möglich, in denen die beiden Schichten 21, 22 beziehungsweise deren Teilbereiche 23, 34 in direktem Kontakt zueinander aufgebracht werden.

Die Hohlräume, die sich durch die Beabstandung zwischen den beiden Schichten 21, 22 ergeben, können vorteilhaft als Entgasungskanäle für Gase dienen, die während der Wärmebehandlung in der ersten Schicht 21 und/oder der zweiten Schicht 22 entstehen. Aber auch bei Ausführungsbeispielen, bei denen die beiden Schichten 21, 22 in direktem Kontakt zueinander aufgebracht werden, können die Gase im Grenzbereich zwischen den beiden Schichten 21, 22 entweichen. Dabei handelt es sich insbesondere um Gase, die aus den für die Schichtherstellung verwendeten Zusatzstoffen wie beispielsweise Lösungsmitteln während der Wärmebehandlung entstehen.

Die Prozessfläche, an der sich während der Wärmebehandlung eine Verbindung zwischen der ersten Schicht 21 und den beiden Lötpartnern 10, 15 ausbilden könnte, ist bei dem erfindungsgemäßen Verfahren durch die nebeneinander aufgebrachten Schichten 21, 22 verglichen mit vollflächig aufgebrachten Schichten reduziert. Dennoch haben Untersuchungen von Schliffen von nach dem erfindungsgemäßen Verfahren hergestellten Lötverbindungen 20 gezeigt, dass auf diese Weise eine besonders große Anbindungsfläche erzielt werden kann. Der sich positiv auf die effektiv erzielte Anbindungsfläche der Lötverbindung 20 auswirkende Effekt der ermöglichten Entgasung überwiegt also den Effekt der geringeren Prozessfläche zwischen der ersten Schicht 21 und den beiden Lötpartnern 10, 15.

In Fig. 3a beziehungsweise Fig. 3b ist ein alternatives Ausführungsbeispiel für eine Ausbildung eines Kontaktbereiches, wie er zur Herstellung einer Lötverbindung 20 gemäß Fig. 1 verwendet werden kann, dargestellt. Man erkennt in diesem Ausführungsbeispiel, wie in dem in Fig. 2 dargestellten, eine aus zwei ersten Teilbereichen 23a bestehende erste Schicht 21a und eine aus drei zweiten Teilbereichen 24a bestehende zweite Schicht 22a, wobei die zweiten Teilbereiche 24a der zweiten Schicht 22a zwischen den ersten Teilbereichen 23a und um die ersten Teilbereiche 23a der ersten Schicht 21a angeordnet sind.

Wie in Fig. 3a dargestellt überragen in diesem Ausführungsbeispiel die zweiten Teilbereiche 24a der zweiten Schicht 22a die ersten Teilbereiche 23a der ersten Schicht 21a. Das elektronische Bauteil 15 wird zunächst auf die überragenden zweiten Teilbereiche 24a der zweiten Schicht 22a aufgelegt.

Vor Beginn des Lötprozesses wird das elektronische Bauteil 15 wie in Fig. 3b dargestellt durch Andrücken auf die Höhe der ersten Schicht 21a gebracht. Andrücken bedeutet dabei im Sinne der Erfindung, dass in vertikaler Richtung eine Anpresskraft auf das elektronische Bauteil 15 in Richtung des Trägerelements 10 ausgeübt wird. Das Andrücken kann beispielsweise maschinell oder manuell erfolgen.

Dadurch, dass das elektronische Bauteil 15 wie in Fig. 3b dargestellt durch Andrücken auf die Höhe der ersten Schicht 21a gebracht wird, also auf dieser aufliegt, gilt auch hier der schon bei der Anordnung gemäß Fig. 2 aufgeführte Vorteil. Bei der Durchführung des Lötprozesses, der weiter unten beschrieben wird, liegt das elektronische Bauteil 15 auch dann auf einer stabilen Unterlage auf, wenn Temperaturen erreicht werden, bei denen die Verflüssigung der zweiten Schicht 22a einsetzt.

Die erste Schicht 21, 21a und die zweite Schicht 22, 22a bilden jeweils Kontaktierzonen für das elektronische Bauteil 15, bei dem es sich wie oben aufgeführt in den hier beschriebenen Ausführungsbeispielen um ein SMD-Bauteil handelt, aus. Ein beispielsweise gemäß Fig. 2 oder Fig. 3 mit SMD-Bauteilen 15 bestücktes Trägerelement 10 wird zur Ausbildung der Lötverbindung 20 einer Wärmebehandlung unterzogen.

Eine derartige Wärmebehandlung findet insbesondere in einem aus dem Stand der Technik bereits bekannten Reflow-Ofen statt, bei dem die Trägerelemente 10 im Durchlaufverfahren durch den Reflow-Ofen durchgeschleust werden. Beispielhaft beträgt die Durchlaufzeit der Trägerelemente 10 durch den Reflow-Ofen zehn Minuten, und die maximale, im Reflow-Ofen herrschende Prozesstemperatur beträgt 280°C.

Beim Durchschleusen des Trägerelements 10 durch den Reflow-Ofen steigt die Temperatur der Schichten 21, 21a und 22, 22a an. Wesentlich dabei ist, dass bei den in diesem Ausführungsbeispiel verwendeten Materialien beim Erreichen einer Temperatur von 180°C die Metallpartikel der ersten Schicht 21, 21a versintern und dabei eine Hohlräume aufweisende Gitterstruktur ausbilden, die eine gewisse mechanische Stabilität aufweist.

Dabei ist die zweite Schicht 22, 22a noch im festen Zustand, d.h. nicht verflüssigt. Bei den in diesem Ausführungsbeispiel verwendeten Materialien verflüssigt sich die zweite Schicht 22, 22a erst bei einer Temperatur von 200°C. Andere Temperaturen sind je nach Art der für die erste Schicht 21, 21a verwendeten Materialien und des für die zweite Schicht 22, 22a verwendeten Lots möglich.

Typische maximale Schmelztemperaturen des Lots bzw. der zweiten Schicht 22, 22a liegen dabei im Bereich von etwa 250°C, wobei die an der zweiten Schicht 22, 22a erreichte Temperatur lediglich etwas oberhalb der Schmelztemperatur der zweiten Schicht 22, 22a liegen sollte. Hierdurch wird erreicht, dass die Höchsttemperatur, der das Schaltungsbauteil 1 während der Wärmebehandlung ausgesetzt ist, möglichst gering gehalten wird.

Wesentlich ist, dass das verflüssigte Material der zweiten Schicht 22, 22a in die Hohlräume bzw. Poren der Gitterstruktur der versinterten ersten Schicht 21, 21a eindringt und diese verschließt. Insbesondere findet das Verschließen der Poren der Gitterstruktur der ersten Schicht 21, 21a auch an einer Oberfläche der ersten Schicht 21, 21a statt, so dass nach dem Erstarren bzw. dem Durchlaufen des Reflow-Ofens das Material der zweiten Schicht 22, 22a nicht nur die Lötverbindung 20 zum SMD-Bauteil 15 herstellt, sondern auch für eine zumindest abschnittsweise porenfreie, d.h. glatte Oberfläche der Schichten 21, 21a und 22, 22a an der Verbindungs- bzw. Fügestelle zum Bauteil 15 sorgt.

Insgesamt sind bei dem in diesem Ausführungsbeispiel beschriebenen Verfahren die Materialien für die erste Schicht 21, 21a und für die zweite Schicht 22, 22a also so gewählt, dass in der ersten Schicht 21, 21a eine Versinterung bei einer niedrigeren Temperatur stattfindet als die Verflüssigung der zweiten Schicht 22, 22a.

Das erfindungsgemäße Verfahren zum Herstellen einer Lötverbindung 20 ist nicht auf die Ausbildung einer Lötverbindung 20 zwischen einem elektronischen Bauelement 15 und einem Trägerelement 10 in Form einer Leiterplatte beschränkt. Das erfindungsgemäße Verfahren kann beispielsweise ebenfalls dazu eingesetzt werden, ein gesamtes Schaltungsbauteil 1 und eine Kühlplatte zu kontaktieren.

## Patentansprüche

1. Verfahren zum Herstellen einer Lötverbindung (20), bei dem auf ein Trägerelement (10) wenigstens eine erste Schicht (21, 21a) und eine zweite Schicht (22, 22a) aufgebracht werden, wobei die erste Schicht (21, 21a) zumindest Metallpartikel und Zusatzstoffe, insbesondere Flussmittel, aufweist, wobei die zweite Schicht (22, 22a) zumindest Lotmittel aufweist, wobei das Trägerelement (10) und die wenigstens zwei Schichten (21, 21a; 22, 22a) anschließend einer Wärmebehandlung unterzogen werden, bei der die zweite Schicht (22, 22a) verflüssigt wird und in die Struktur der ersten Schicht (21, 21a) eindringt, wobei die erste Schicht (21, 21a) und die zweite Schicht (22, 22a) ohne gegenseitige Überdeckung auf das Trägerelement (10) aufgebracht werden,
**dadurch gekennzeichnet,**
**dass** als Metallpartikel für die erste Schicht (21, 21a) Partikel aus Kupfer, Bronze, Nickel,_{Zink oder Messing} mit einer Partikelgröße zwischen 1 µm und 100 µm verwendet werden, und wobei einer der Zusatzstoffe Lotpulver ist, insbesondere Lotpulver mit einer Körnung von 1 µm bis 100 µm.

2. Verfahren nach Anspruch 1,
**dadurch gekennzeichnet,**
**dass** im Verlauf der Wärmebehandlung zunächst die Metallpartikel der ersten Schicht (21, 21a) unter Bildung einer Hohlräume aufweisenden Gitterstruktur versintern, und dass anschließend das Material der zweiten Schicht (22, 22a) verflüssigt wird und in die Hohlräume bzw. Poren der Gitterstruktur der ersten Schicht (21, 21a) eindringt.

3. Verfahren nach Anspruch 2,
**dadurch gekennzeichnet,**
**dass** das Material der zweiten Schicht (22, 22a) zumindest die an einer Oberfläche der ersten Schicht (21, 21a) aufgrund der Gitterstruktur ausgebildeten Poren auffüllt.

4. Verfahren nach einem der Ansprüche 1 bis 3,
**dadurch gekennzeichnet,**
**dass** die erste Schicht (21, 21a) eine Anordnung aus mehreren ersten Teilbereichen (23, 23a) umfasst, dass die zweite Schicht (22, 22a) eine Anordnung aus mehreren zweiten Teilbereichen (24, 24a) umfasst, und dass die zweiten Teilbereiche (24, 24a) zwischen den ersten Teilbereichen (23, 23a) und/oder um die ersten Teilbereiche (23, 23a) angeordnet sind.

5. Schaltungsbauteil (1) mit einem, insbesondere als Leiterplatte ausgebildeten, Schaltungsträger (10) und mit mindestens einem elektronischen Bauteil (15), wobei das elektronische Bauteil (15) auf mindestens einem elektrisch leitenden Bereich (11, 12) des Schaltungsträgers (10) angeordnet ist, hergestellt nach einem Verfahren nach einem der Ansprüche 1 bis 4.

## Claims

1. Method for creating a soldered connection (20), in which at least a first layer (21, 21a) and a second layer (22, 22a) are deposited onto a support element (10), wherein the first layer (21, 21a) has at least metal particles and additives, in particular flux, wherein the second layer (22, 22a) has at least solder, wherein the support element (10) and the at least two layers (21, 21a; 22, 22a) then undergo heat treatment in which the second layer (22, 22a) is melted and penetrates into the structure of the first layer (21, 21a), wherein the first layer (21, 21a) and the second layer (22, 22a) are deposited onto the support element (10) without covering one another,
**characterized in that**
the metal particles used for the first layer (21, 21a) are particles of copper, bronze, nickel, zinc or brass with a particle size between 1 µm and 100 µm, and wherein one of the additives is solder powder, in particular solder powder with a grain size of 1 µm to 100 µm.

2. Method according to Claim 1,
**characterized in that**,
in the course of the heat treatment, first the metal particles of the first layer (21, 21a) sinter, forming a lattice structure having cavities, and **in that** then the material of the second layer (22, 22a) is melted and penetrates into the cavities or pores of the lattice structure of the first layer (21, 21a) .

3. Method according to Claim 2,
**characterized in that**
the material of the second layer (22, 22a) at least fills the pores formed at a surface of the first layer (21, 21a) owing to the lattice structure.

4. Method according to one of Claims 1 to 3,
**characterized in that**
the first layer (21, 21a) comprises an arrangement of a plurality of first partial regions (23, 23a), **in that** the second layer (22, 22a) comprises an arrangement of a plurality of second partial regions (24, 24a), and **in that** the second partial regions (24, 24a) are arranged between the first partial regions (23, 23a) and/or around the first partial regions (23, 23a).

5. Circuit component (1) having a circuit carrier (10), which is in particular in the form of a circuit board, and having at least one electronic component (15), wherein the electronic component (15) is arranged on at least one electrically conductive region (11, 12) of the circuit carrier (10), produced by a method according to one of Claims 1 to 4.

## Revendications

1. Procédé de fabrication d'une liaison brasée (20), au cours duquel on dépose sur un élément de support (10) au moins une première couche (21, 21a) et une deuxième couche (22, 22a), dans lequel la première couche (21, 21a) présente au moins des particules de métal et des additifs, en particulier un fondant, dans lequel la deuxième couche (22, 22a) présente au moins un métal d'apport, dans lequel on soumet ensuite l'élément de support (10) et les au moins deux couches (21, 21a ; 22, 22a) à un traitement thermique, au cours duquel la deuxième couche (22, 22a) est liquéfiée et pénètre dans la structure de la première couche (21, 21a), dans lequel on dépose la première couche (21, 21a) et la deuxième couche (22, 22a) sans recouvrement mutuel sur l'élément de support (10),
**caractérisé en ce que**
l'on utilise comme particules de métal pour la première couche (21, 21a) des particules de cuivre, de bronze, de nickel, de zinc ou de laiton avec une taille de particules comprise entre 1 µm et 100 µm, et dans lequel un des additifs est une poudre d'apport, notamment une poudre d'apport avec une taille de grain de 1 µm à 100 µm.

2. Procédé selon la revendication 1,
**caractérisé en ce que**
au cours du traitement thermique, d'abord les particules de métal de la première couche (21, 21a) se frittent en formant une structure de grille présentant des cavités, et ensuite le matériau de la deuxième couche (22, 22a) se liquéfie et pénètre dans les cavités ou les pores de la structure de grille de la première couche (21, 21a).

3. Procédé selon la revendication 2,
**caractérisé en ce que**
le matériau de la deuxième couche (22, 22a) remplit au moins les pores formés sur une surface de la première couche (21, 21a) en raison de la structure de grille.

4. Procédé selon l'une quelconque des revendications 1 à 3,
**caractérisé en ce que**
la première couche (21, 21a) comprend un agencement de plusieurs premières régions partielles (23, 23a), **en ce que** la deuxième couche (22, 22a) comprend un agencement de plusieurs deuxièmes régions partielles (24, 24a), et **en ce que** les deuxièmes zones partielles (24, 24a) sont agencées entre les premières zones partielles (23, 23a) et/ou autour des premières zones partielles (23, 23a).

5. Composant de circuit (1) comprenant un support de circuit (10), en particulier configuré en tant que circuit imprimé, et comprenant au moins un composant électronique (15), dans lequel le composant électronique (15) est agencé sur au moins une zone électriquement conductrice (11, 12) du support de circuit (10), fabriqué par un procédé selon l'une quelconque des revendications 1 à 4.
